# EUROPÄISCHE PATENTSCHRIFT

(11) **EP 2 734 818 B1**
(45) Veröffentlichungstag und Bekanntmachung des Hinweises auf die Patenterteilung: **16.01.2019**
(21) Anmeldenummer: 12726095.8
(22) Anmeldetag: 05.06.2012
(51) Int. Cl.: G01F 1/58

(54) **MAGNETISCH-INDUKTIVES DURCHFLUSSMESSGERÄT**
ELECTROMAGNETIC FLOWMETER
DÉBITMÈTRE ÉLECTROMAGNÉTIQUE

(30) Priorität: 18.07.2011 DE 102011079351
(43) Veröffentlichungstag der Anmeldung: 28.05.2014
(73) Patentinhaber: Endress+Hauser Flowtec AG, 4153 Reinach (BL) (CH)
(72) Erfinder: VOIGT, Frank, 79576 Weil am Rhein (DE); BÄHR, Günther, CH-4106 Therwil (CH); UERLINGS, Diego, 79639 Grenzach-Wyhlen (DE); WOHLGEMUTH, Werner, CH-4206 Seewen (CH)
(74) Vertreter: Andres, Angelika Maria
(86) Internationale Anmeldenummer: PCT/EP2012/060552
(87) Internationale Veröffentlichungsnummer: WO 2013/010715

(56) Entgegenhaltungen:
- EP-A1- 0 990 876
- EP-A1- 1 522 828
- EP-A1- 2 019 294
- DE-A1-102007 029 563
- US-A- 2 734 380

## Beschreibung

Die vorliegende Erfindung betrifft ein magnetisch-induktives Durchflussmessgerät mit einem Messrohr und zumindest einem am Messrohr angeordnetem Magnetsystem.

Magnetisch-induktive Durchflussmessgeräte nutzen für die volumetrische Strömungsmessung das Prinzip der elektrodynamischen Induktion aus und sind aus einer Vielzahl von Veröffentlichungen bekannt. Senkrecht zu einem Magnetfeld bewegte Ladungsträger des Mediums induzieren eine Messspannung in im Wesentlichen senkrecht zur Durchflussrichtung des Mediums und senkrecht zur Richtung des Magnetfeldes angeordneten Messelektroden. Die in die Messelektroden induzierte Messspannung ist proportional zu der über den Querschnitt des Messrohres gemittelten Strömungsgeschwindigkeit des Mediums, also proportional zum Volumenstrom. Ist die Dichte des Mediums bekannt, lässt sich der Massestrom in der Rohrleitung bzw. in dem Messrohr bestimmen. Die Messspannung wird üblicherweise über ein Messelektrodenpaar abgegriffen, das bezüglich der Koordinate entlang der Messrohrachse in dem Bereich maximaler Magnetfeldstärke angeordnet ist und wo folglich die maximale Messspannung zu erwarten ist. Die Elektroden sind üblicherweise galvanisch mit dem Medium gekoppelt; es sind jedoch auch magnetisch-induktive Durchflussmessgeräte mit berührungslos kapazitiv koppelnden Elektroden bekannt.

Das Messrohr kann dabei entweder aus einem elektrisch leitfähigen, nichtmagnetischen Material, z.B. Edelstahl, gefertigt sein, oder aus einem elektrisch isolierenden Material bestehen. Ist das Messrohr aus einem elektrisch leitfähigen Material gefertigt, so muss es in dem mit dem Medium in Kontakt kommenden Bereich mit einem Liner aus einem elektrisch isolierenden Material ausgekleidet sein. Der Liner besteht je nach Temperatur und Medium beispielsweise aus einem thermoplastischen, einem duroplastischen oder einem elastomeren Kunststoff. Es sind jedoch auch magnetisch-induktive Durchflussmessgeräte mit einer keramischen Auskleidung bekannt.

Aus der US 2004/0149046 A1 ist ein elektromagnetisches Durchflussmessgerät mit einem Messrohr bekannt, welches eine ebene Fläche und eine ansonsten zylindrische Fläche aufweist. Auf der ebenen Fläche ist ein Polschuh eines Magnetsystems angeordnet. Dabei ist der Polschuh, der innere Kern und die Spule an einem äußeren Kern (Rückführung) durch eine Verschraubungvor Verrutschen gesichert. Ungünstig bei dieser Ausgestaltung ist das bestimmungsgemäss vollflächige formschlüssige Aufliegen des Polschuhs auf dem Messrohr, was hohe Anforderungen an die Toleranzen stellt. Problematisch ist die mechanisch wenig stabile Fixierung des Polschuhs auf dem Messrohr nur über den äusseren Kern. Dies kann bei Vibrationen zu einer Beeinträchtigung des Mess-Signals führen.

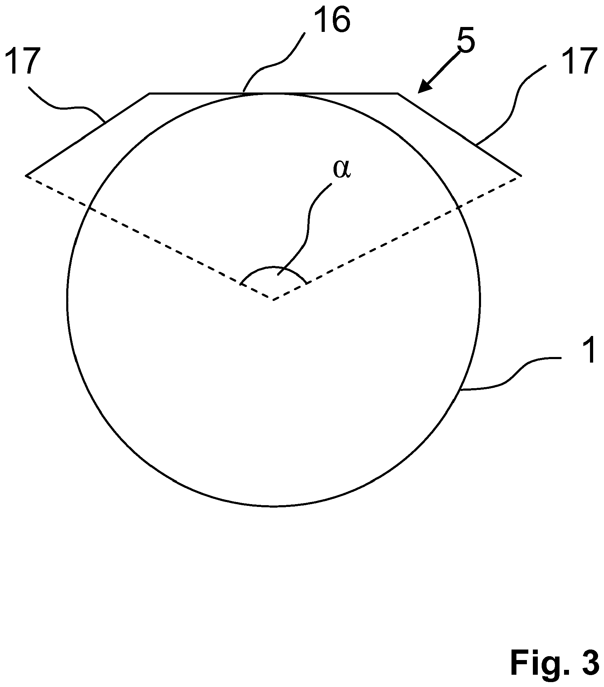

Die US 2,734,380 offenbart ein magnetisches Durchflussmessgerät mit einem Messrohr, bei dem die Polschuhe zweier Magnetspulen auf einer flachen Fläche aufliegen. Die beiden Magnetkerne werden durch aussenliegende Bolzen (126 in der Schrift, Fig. 3) am Messrohr fixiert. Nachteilig ist bei dieser Gestaltung, dass mehrere Bolzen notwendig sind und dass bei einem nichtsymmetrischen Anzugsmoment zusätzliche Messabweichungen auftreten können..

Die EP 1 674 836 A1 offenbart ein magnetisch-induktives Durchflussmessgerät mit einer Spule und wenigstens zwei lösbar miteinander verbundenen Bauteilen, wobei das Bauteil flach auf einem Bereich einer rechtwinkligen Messleitung aufliegt und durch ein Aussenrohr auf dieser Messleitung gehalten wird. Toleranzen im Aussendurchmesser des Messrohres werden dabei durch ein flexibles Blech ausgeglichen, welches den Kern und über den Kern den Polschuh gegen das Messrohr drückt. Nachteilig ist bei dieser Gestaltung, dass die Kraft, mit der das Blech auf den Kern drückt, aufgrund der geringen Dicke relativ schwach ist, was die Empfindlichkeit des Messgerätes und die Stabilität z.B. bei Vibrationen nachteilig beeinflussen kann.

Die US 5,751,535 offenbart ein elektronisches Durchflussmessgerät mit einem zylindrischen Messrohr und daran aufliegenden Polschuhen eines Magneten. Nachteilig sind bei dieser Ausgestaltungsvariante insbesondere die von den Rohrtoleranzen abhängigen Öffnungswinkel des Polschuhs, da die Auflagepunkte nicht über eine ebene bearbeitete Fläche definiert sind, sondern über den Kontakt der Polschuhe am Umfang des Messrohres. Je nach Durchmesser oder Abweichung von der idealen Rundheit des Messrohres ändern sich die Auflagepunkte des Polschuhs auf dem Messrohr. Wenn bei der Montage der Polschuh gegen das Messrohr gedrückt wird, biegen sich die Schenkel abhängig von der Messrohrgeometrie und der aufgebrachten Kraft auf. Dies kann zu einer zusätzlichen Messabweichung führen.
Die DE 103 06 522 offenbart ein System zum effizienten und verwechslungssicheren Montieren und Fixieren eines Magnetsystems auf ein Rohr mit eher geringem Durchmesser. Dies wird insbesondere durch eine vorteilhafte Gestaltung des Spulenkörpers, des Spulenkerns und der Feldrückführung erreicht, welche bei grösseren Rohrdurchmessern weniger vorteilhaft ist.

Die DE 35 45 155 offenbart unter anderem die Fixierung eines Magnetsystems an einem mehrteilig aufgebauten Gehäuse anstatt direkt am Messrohr (Fig. 3 in der Patentschrift). Nachteilig ist hier, dass je nach den Abmessungen und Toleranzen der Bauteile ein Abstand zwischen Polschuh und Messrohr auftreten kann oder das Gehäuse nicht über den Kern passt.

Eine Elektrode lässt sich im Wesentlichen in einen Elektrodenkopf, der zumindest teilweise mit einem Medium, welches das Messrohr durchströmt, in Kontakt kommt, und einen Elektrodenschaft, der fast vollständig in der Wandung des Messrohres eingebracht ist, unterteilen.

Die Elektroden sind neben dem Magnetsystem die zentralen Komponenten eines magnetisch-induktiven Durchflussmessgerätes. Bei der Ausgestaltung und Anordnung der Elektroden ist darauf zu achten, dass sie sich möglichst einfach in dem Messrohr montieren lassen und dass nachfolgend im Messbetrieb keine Dichtigkeitsprobleme auftreten; darüber hinaus sollen sich die Elektroden durch eine empfindliche und gleichzeitig störungsarme Messsignalerfassung auszeichnen.

Neben den Messelektroden, die zum Abgriff eines Messsignals dienen, werden oftmals zusätzliche Elektroden in Form von Bezugs- oder Erdungselektroden in das Messrohr eingebaut, die dazu dienen, ein elektrisches Referenzpotential zu messen oder teilgefüllte Messrohre zu erkennen oder die Mediumstemperatur mittels eingebautem Temperaturfühler zu erfassen.

Die US 2,734,380 A offenbart in den Fig. 3 und 4 ein Messrohr mit einer ebenen Fläche. Auf dieser ebenen Fläche ist ein Magnetsystem angeordnet. Dieses Magnetsystem zeigt eine Magnetspue 30 oder 32. Diese Spule ist auf einem "contact piece 108" aus isolierendem Material angeordnet, welches endständig mit Silberleitlack 110 überzogen ist. (Spalte 4 Zeile 10 ff.).

Die EP 2 019 294 A1 zeigt eine Kompaktvariante eines magnetisch-induktiven Durchflussmessgerätes. Man erkennt flache Seitensegmente im Messrohr, die zum Ausgleich der zylindrischen Mantelfläche im Messrohr eingebracht sind. Auch die D2 zeigt in Fig. 2 eine auf einen Stift aufgesteckte Magnetspule, die irgendwie fixiert ist.

Die EP 1 522 828 A1 offenbart eine Wickelvariante eines magnetisch-induktiven Durchflussmessgerätes. Das Messrohr setzt sich aus Faserverbundwerkstoffen und Vergussmasse zusammen, wobei in die Faserverbundlagen Metallfolien als Elektroden eingebaut sind.

Die EP 0 990 876 A1 zeigt ein System aus der Familie der Sattelspulen-Durchflussmessgeräte. Die in den Figuren dargestellte Variante der Sattelspule liegt am Polschuh an. Das Gesamtkonstrukt ist lediglich durch den Spannring 23 gehalten und wird mutmaßlich nur durch die Messelektroden am Messrohr festgelegt.

Die DE 10 2007 029 563 A1 zeigt ein gattungsgemäßes magnetisch-induktives Durchflussmessgerät aus dem Stand der Technik. Dieses Gerät weist einen im Sensorgehäuse integrierten Transmitter auf.

Die Aufgabe der Erfindung besteht darin, ein einfach und kostengünstig herzustellendes magnetisch-induktives Durchflussmessgerät vorzuschlagen.

Die Aufgabe wird gelöst durch die Gegenstände der unabhängigen Ansprüche 1 und 2, sowie 13 und 14. Weiterbildungen und Ausgestaltungen der Erfindung finden sich in den Merkmalen der jeweils abhängigen Ansprüche wieder.

Die Erfindung lässt zahlreiche Ausführungsformen zu. Einige davon sollen hier kurz anhand der nachfolgenden Figuren näher erläutert werden. Gleiche Elemente sind in den Figuren mit gleichen Bezugszeichen versehen.
- Fig. 1: zeigt perspektivisch ein erfindungsgemäßes magnetisch-induktives Durchflussmessgerät vor der Montage des Magnetsystems,
- Fig. 2: zeigt das Magnetsystem eines erfindungsgemäßen magnetisch-induktiven Durchflussmessgeräts in einer Explosionsdarstellung,
- Fig. 3: zeigt ein erfindungsgemäßes magnetisch-induktives Durchflussmessgerät vereinfacht in einer Prinzipskizze im Querschnitt,
- Fig. 4: zeigt ein erfindungsgemäßes magnetisch-induktives Durchflussmessgerät in einer weiteren Ausgestaltung.

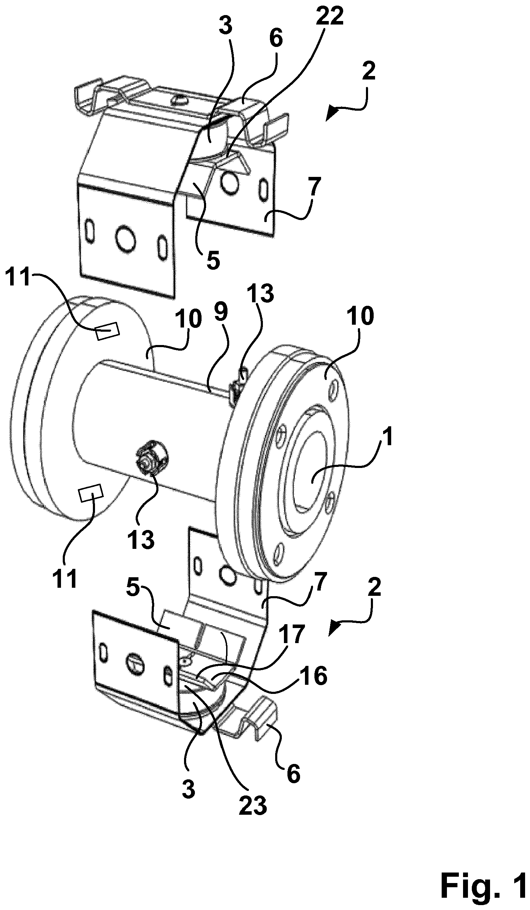

Fig. 1 zeigt perspektivisch einzelne Baugruppen eines erfindungsgemäßen magnetisch-induktiven Durchflussmessgeräts. Ein Messrohr 1 weist eine ebene Fläche 9 auf einer ansonsten kreiszylindrischen Mantelfläche, und einen im Wesentlichen kreisförmigen Innendurchmesser, auf. Das Messrohr 1 wird beispielsweise durch Materialabtragung, z.B. durch Abfräsen, mit dieser ebenen Fläche 9 versehen oder es wird mitsamt der ebenen Fläche 9 urgeformt, z.B. gegossen. Insbesondere weist das Messrohr 1 einen ansonsten kreisförmigen Querschnitt mit einem abgetragenen Kreissegment auf, mit dem Querschnitt der ebenen Fläche 9 als die das Kreissegment begrenzende Kreissehne. Die Mantelfläche und die ebene Fläche 9 grenzen das Messrohr auf seiner Außenseite zur Umwelt hin ab.

Das Messrohr 1 weist hier stirnseitig Flansche 10 auf. In die Messrohrwand sind darüber hinaus Elektroden 13 und 15 eingebracht. In einem Ausführungsbeispiel der Erfindung berühren die Elektroden 13 und 15 den Messstoff im Messrohr 1. Eine Elektrode 15 ragt dabei nach außen aus der ebenen Fläche 9 des Messrohrs 1 heraus. Diese dient beispielsweise als Messstoffüberwachungselektrode.

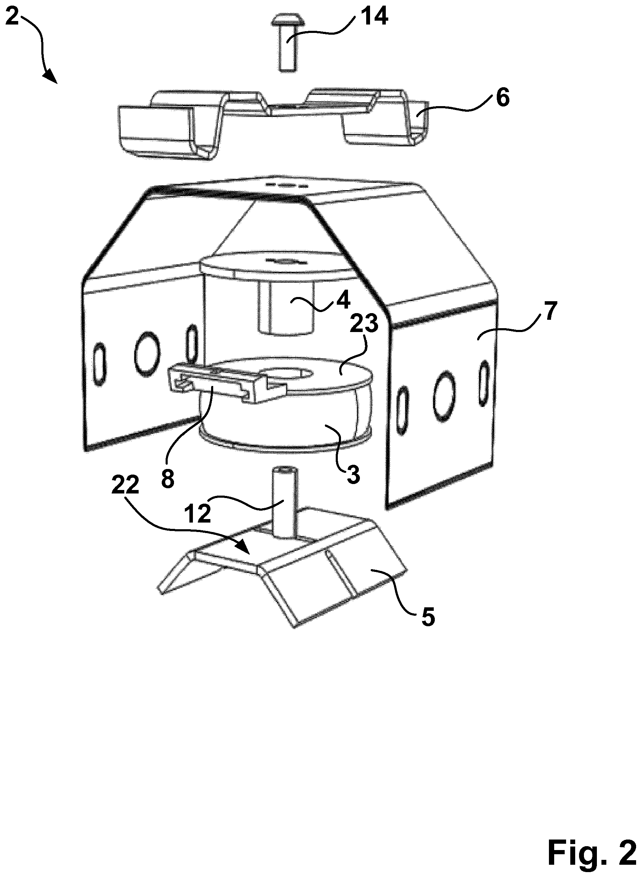

Als zweite Baugruppe ist ein Magnetsystem 2 skizziert. Es umfasst einen Polschuh 5 und eine Spule 3. Hier umfasst es zusätzlich ein gebogenes Blech als Feldrückführung 7 und einen Montageclip 6. Das Magnetsystem 2 ist detailliert in der Beschreibung zur Fig. 2 beschrieben. Es wird beispielsweise auf dem Messrohr 1 angeordnet, indem es auf die ebene Fläche 9 aufgesetzt und mit einer vorgegebenen Kraft daran gedrückt gehalten wird. Dann ist es erfindungsgemäß gegen die ebene Fläche 9 vorgespannt.

In der gezeigten Weiterbildung ist das Magnetsystem 2 mittels eines Montageclips 6 gegen die ebene Fläche 9 des Messrohrs 1 vorgespannt. Der Montageclip 6 ist hier am Flansch 10 des Messrohrs 1 formschlüssig befestigt. Dazu weist der Flansch 10 eine Ausnehmung 11 auf, in welche der Montageclip 6 eingreift.

Der Montageclip 6 ist somit formschlüssig mit dem Messrohr 1, hier mit seinen Flanschen 10, und das Magnetsystem 2 ist kraftschlüssig mit dem Messrohr 1 verbunden. Der Montageclip 6 weist dabei eine vorgegebene Elastizität auf. Er dient als federndes Spannelement.

Im gezeigten Ausführungsbeispiel verläuft der Kraftfluss der Andrückkraft vom Montageclip 6 über den Spulenkern 4 der Spule 3 und den Polschuh 5 zur ebenen Fläche 9 des Messrohrs 1. Zwischen Montageclip 6 und Spule 3 ist zusätzlich die Feldrückführung 7 angeordnet, durch welche die Kraftleitung erfolgt. Montageclip 6, Feldrückführung 7, Spule 3 und Polschuh 5 sind dabei als eine Baugruppe über eine Schraube 14 miteinander verbunden. Gemäß einer weiteren Ausgestaltung drückt der Montageclip 6 den Spulenkern 4 der Spule 3 gegen den Polschuh 5 und diesen somit gegen die ebene Fläche 6 des Messrohrs 1.

Der Polschuh 5, welcher gegen die ebene Fläche 9 des Messrohrs 1 gedrückt wird, ist dabei so geformt, dass er die ebene Fläche 9 des Messrohrs 1 berührt und einen vorgegebenen Mindestabstand größer Null zur ansonsten zylindrischen Mantelfläche des Messrohrs 1 aufweist. Dabei umschließt er das Messrohr 1 in einem Kreisbogenwinkel von zumindest 10°, insbesondere zumindest 30°, beispielsweise gar 60°. Hier weist der Polschuh 5 selbst eine erste ebene Fläche 16 auf, welche auf der ebenen Fläche 9 des Messrohrs 1 aufliegt.

Die erste ebene Fläche 16 des Polschuhs 5 weist hier eine Breite auf, welche größer ist als die Breite der ebenen Fläche 9 des Messrohrs 1. Die Breiten werden dabei gemessen parallel zur ebenen Fläche 9 des Messrohrs 1 und orthogonal zur in die ebene Fläche 9 des Messrohrs projizierten Messrohrachse des Messrohrs 1.

Der Polschuh darf gemäß einer hier nicht dargestellten Ausführungsform der Erfindung das Messrohr auch an dessen Mantelfläche außerhalb der ebenen Fläche berühren, beispielsweise tangiert er es in zwei, zur Messrohrachse parallelen und auf verschiedenen Hälften des Messrohrs verlaufenden Geraden, beispielsweise jeweils einmal mit seinen Schenkeln. Jedoch darf der Polschuh erfindungsgemäß nicht durch die Art und Weise seiner Befestigung am Messrohr deformiert werden, insbesondere darf seine Form nicht durch mechanische Spannungen über ein vorgegebenes Maß hinaus verändert werden. Daher wird er erfindungsgemäß mit einer vorgegebenen und damit limitierten Kraft gegen das Messrohr vorgespannt. Die Kraft mit welcher das Magnetsystem, respektive der Polschuh auf die ebene Fläche des Messrohrs vorgespannt wird, zeigt senkrecht auf die ebene Fläche des Messrohrs und beträgt höchstens 2000 N, insbesondere höchstens 100 N. Sie ist natürlich abhängig von der Dicke des Polschuhs 5. Zwischen Polschuh 5 und Spulenkern 4 sowie zwischen Spulenkern 4 und Feldrückführung 7 sollen keine Luftspalte entstehen, wie sie sich beispielsweise zwischen Polschuh 5 und Spulenkern 4 dadurch bilden können, dass der Polschuh 5 durch zusätzliches Aufliegen an der kreiszylindrischen Mantelfläche des Messrohrs 1 deformiert wird. Hier berührt der Polschuh 5 darüber hinaus lediglich die Ebene Fläche 9 des Messrohrs.

Die Kraft der Vorspannung ist zu vernachlässigen, wenn der Spulenkern 4 der Spule 3 eine zum Polschuh 5 im montierten Zustand komplementäre Kontur aufweist. Der Spulenkern 4 berührt den Polschuh 5 mit einer Fläche, welche eine zum Polschuh 5 komplementäre Kontur aufweist, so dass der Spulenkern 4 den Polschuh 5 quasi spaltfrei berührt. Der Polschuh 5 weist dazu beispielsweise eine, im nicht-montierten Zustand, zur ersten ebenen Fläche 16 planparallele zweite ebene Fläche 22 auf. Der Spulenkern 4 liegt mit seiner komplementären, ebenen Fläche auf dem Polschuh 5 auf der Fläche 22 auf. Der Polschuh 5 ist so zum Messrohr 1 ausgestaltet, dass die zweite ebene Fläche 22 auch im montierten Zustand plan oder komplementär zur gegenüberliegenden Kontur des Spulenkerns 4 ist.

Tangiert der Polschuh 5 beispielsweise mit seinen Schenkeln 17 die kreiszylindrische Mantelfläche des Messrohrs 1 und liegt dabei mit seiner ebenen Fläche 16 noch nicht auf der ebenen Fläche 9 des Messrohrs 1 auf, könnte die Vorspannung des Polschuhs 5 gegen das Messrohr 1 eine Deformation des Polschuhs 5 erzeugen, beispielsweise in der Art, dass die erste ebene Fläche 16 und damit auch die dazu planparallele zweite ebene Fläche 22 durch eine eingeleitete Biegespannung eine Biegung erfährt, so dass die zweite, zunächst ebene Fläche 22 die Form einer einfach oder gar doppelt gekrümmten Schale annimmt. Eine Spule 3 mit einem Spulenkern 4, welcher ebenfalls eine ebene Fläche aufweist, mit welcher er auf der zweiten, zunächst ebenen Fläche 22 zunächst flächig aufliegt, würde im montierten Zustand, nach dem Aufbringen der Vorspannung und der damit verbundenen Biegung des Polschuhs 5 den Polschuh 5 nicht mehr spaltfrei berühren. Die Kraft der Vorspannung spielt dabei nur eine untergeordnete Rolle. Entscheidender ist die Ausgestaltung des Polschuhs 5. Dessen Maße sind daher zum Messrohr 1 so abgestimmt, dass er im montierten Zustand, wenn er, insbesondere seine ebene Fläche 16, die ebene Fläche 9 des Messrohrs 1 berührt, einen vorgegebenen Mindestabstand zur ansonsten zylindrischen Mantelfläche des Messrohrs 1 aufweist, also die kreiszylindrische Mantelfläche des Messrohrs 1 nicht berührt, oder im Grenzfall sie lediglich tangiert, beispielsweise in zwei zur Messrohrachse parallelen Geraden.

Der Polschuh 5 ist beispielsweise symmetrisch aufgebaut, insbesondere spiegelsymmetrisch, mit einer Spiegelebene, in welcher die Messrohrachse liegt und welche die ebene Fläche 9 des Messrohrs senkrecht schneidet, und diese dabei insbesondere in zwei gleich große Teile teilt.

Hier weist der Polschuh 5 zwei an die ebene Fläche 16, 22 angrenzende Schenkel 17 auf, welche jeweils denselben Winkel zur ersten ebenen Fläche 16 und dieselbe Größe aufweisen. Alternativ kann der Polschuh 5 z.B. auch zwei an seiner ebenen Fläche 16, 22 angebrachten Kreisbögen aufweisen.

Zu sehen ist weiterhin eine weitere Elektrode 13, welche aus dem Messrohr 1 herausragt. Ihre Längsachse liegt hier in einer Ebene, parallel zur ebenen Flächen 9 des Messrohrs 1. Dabei handelt es sich um eine von zwei sich gegenüberliegend im Messrohr 1 angeordneten Messelektroden. Die Feldrückführung 7 umschließt im montierten Zustand das Messrohr 1 in zumindest einer auf die Messrohrachse senkrecht stehenden Ebene. Dabei werden auch die Messelektroden umschlossen. Beide Feldrückführungen 7 können sich dabei überlappen und gegenseitig miteinander verbunden werden, beispielsweise durch eine Verschraubung oder einen weiteren, federnd wirkenden Montagclip. Dies erhöht die mechanische Stabilität des Gesamtsystems. Wie üblich umschließen die Feldrückführungen 7 das Messrohr 1 vollständig. Die aus der ebenen Fläche 9 des Messrohrs 1 herausragende Elektrode 15 wird hier dagegen nicht von der Feldrückführung 7 umschlossen. Sie ist axial versetzt zu den Messelektroden und wird vom Montageclip 6 gegen mechanische Einflüsse von außen abgeschirmt, da dieser sie zumindest teilweise vom Messrohr 1 wegweisend abdeckt.

Nicht zu sehen ist, dass das Messrohr 1 in dieser Weiterbildung der Erfindung eine zur ebenen Fläche 9 planparallele, und damit auch zur Messrohrachse parallele, weitere ebene Fläche aufweist, gegen welche ein weiteres Magnetsystem 2 vorgespannt wird. Die zweite ebene Fläche liegt auf der gegenüberliegenden Seite des Messrohrs 1. Sie ist ansonsten identisch zur ersten ebenen Fläche 9. Auch beide Magnetsysteme 2 sind gleich aufgebaut und hergestellt und werden somit gleichermaßen montiert. Durch die Gleichteile, wie z.B. Spulen, Spulenkerne, Polschuhe, Feldrückführungen und Montageclips ist das erfindungsgemäße magnetisch-induktive Durchflussmessgerät kostengünstig herzustellen.

In einer Variante der Erfindung sind die genannten Bauteile des Magnetsystems dermaßen ausgestaltet, dass sie auch mit ähnlich aufgebauten, jedoch unterschiedliche Größen aufweisenden Bauteilen eines Baukastensystems kombinierbar sind. So lassen sich verschiedene Magnetsysteme für Messrohre unterschiedlicher Durchmesser oder Längen einfach und sicher herstellen.

Eine weitere Elektrode kann zur Erdung vorgesehen werden. Alternativ ist die Erdung über die Flansche 10 und den daran angebrachten Montageclip 6 vorzunehmen oder in einer alternativen Ausgestaltung über den mit dem Messrohr elektrisch leitfähig verbundenen Gewindestift 18.

Signalkabel zur Kontaktierung der Messelektroden werden darüber hinaus beispielsweise durch den Spulenkern der Spule geführt.

In Fig. 2 ist ein erfindungsgemäßes Magnetsystem 2 eines erfindungsgemäßen magnetisch-induktiven Durchflussmessgeräts perspektivisch dargestellt. Es umfasst eine Spule 3 und einen Polschuh 5. Im gezeigten Ausführungsbeispiel umfasst es zusätzlich noch einen Spulenkern 4 und eine Feldrückführung 7 und eine Schraube 14. Durchaus üblich ist auch ein Spulenkern als integraler Bestandteil des Polschuhs. Die 3 Spule umfasst hier einen Spulenkörper 23, um welchen ein Draht aus elektrisch leitfähigem Material, z.B. Kupferdraht gewickelt ist. Am Spulenkörper 23 ist ein Steckverbindungselement 8 zum elektrischen Anschluss der Spule 3 angeordnet. Das Steckverbindungselement 8 ist im montierten Zustand zwischen dem Montageclip 6 und dem Messrohr 1 angeordnet, und ist somit gegen mechanische Einflüsse von außen vom Montageclip geschützt, da es zumindest teilweise von diesem abgeschirmt ist.

Der Polschuh 5 weist einen Stift oder, wie hier eine Buchse mit Innengewinde 12 auf, auf welche die Spule 3 und gegebenenfalls ein Spulenkern 4 aufgesteckt wird. Bei der Montage wird der Polschuh 5 so zum Messrohr 1 ausgerichtet, dass die Gewindebuchse 12 eine Längsachse aufweist, welche mit einem Durchmesser des Messrohrs 1 zusammenfällt.

Polschuh 5, Spule 3 und Spulenkern 4 werden mittels der Schraube 14 fixiert, welche in die Gewindebuchse 12 eingeschraubt wird. Zwischen Spule 3 bzw. Spulenkern 4 und Kopf der Schraube 14 werden hier noch die Feldrückführung 7 und der Montageclip 6 zum fertigen Magnetsystem 2 verschraubt.

Zwei Geraden, welche in einer Ebene senkrecht zur Messrohrachse liegen, und welche die Messrohrachse mit den jeweiligen Enden des Polschuhs 5 verbinden, schließen einen Kreisbogenwinkel ein. Dies ist in der Prinzipskizze von Fig. 3 veranschaulicht, wobei die Zeichenebene die zur Messrohrachse senkrechte Ebene ist, in welcher die beiden Geraden liegen, welchen den Kreisbogenwinkel α einschließen. Eine gedachte, nicht eingezeichnete Symmetrieebene teilt den Kreisbogenwinkel wiederum in zwei gleichgroße Teile, wobei in der Symmetrieebene die Messrohrachse liegt. Hier ist die Symmetrieebene eine Symmetrieebene bezogen sowohl auf das Messrohr 1 als auch auf den Polschuh 5. Der Polschuh 5 umschließt das Messrohr 1 in einem Kreisbogenwinkel α von 0° bis 180°, typischerweise von 10° bis 120°. Ist ein Polschuh 5, wie hier gezeigt, aus drei ebenen Flächen zusammengesetzt umschließt die mittlere ebene Fläche des Polschuhs 5, welche im montierten Zustand die ebene Fläche des Messrohrs 1 berührt, das Messrohr 1 in einem Kreisbogenwinkel von beispielsweise 10°, wobei dann der gesamte Polschuh 5 das Messrohr 1 in einem Kreisbogenwinkel von typischerweise 15° umschließt.

Der erste Winkel ist dabei zwischen den beiden ersten Abkantungen auf den beiden Seiten des Polschuhs, der zweite zwischen den Enden des Polschuhs. Der erste Winkel ist dabei typisch - aber nicht zwingend - mindestens so groß wie der von der Messrohrachse aus aufgespannte Winkel der ebenen Fläche 9, wobei man hierfür die Breite der ebenen Fläche 9 senkrecht zur Messrohrlängsachse als Kreissegment des Messrohrquerschnitts senkrecht zur Messrohrlängsachse betrachtet. Statt einer Abkantung sind auch mehrere Abkantungen denkbar oder ein beliebiger das Messrohr teilweise umschließender Verlauf der Polschuhkontur mit einem vorgegebenen Mindestabstand zur Mantelfläche des Messrohres und einem Maximalabstand begrenzt unter anderem durch die Gehäuseabmessungen des Messaufnehmers.

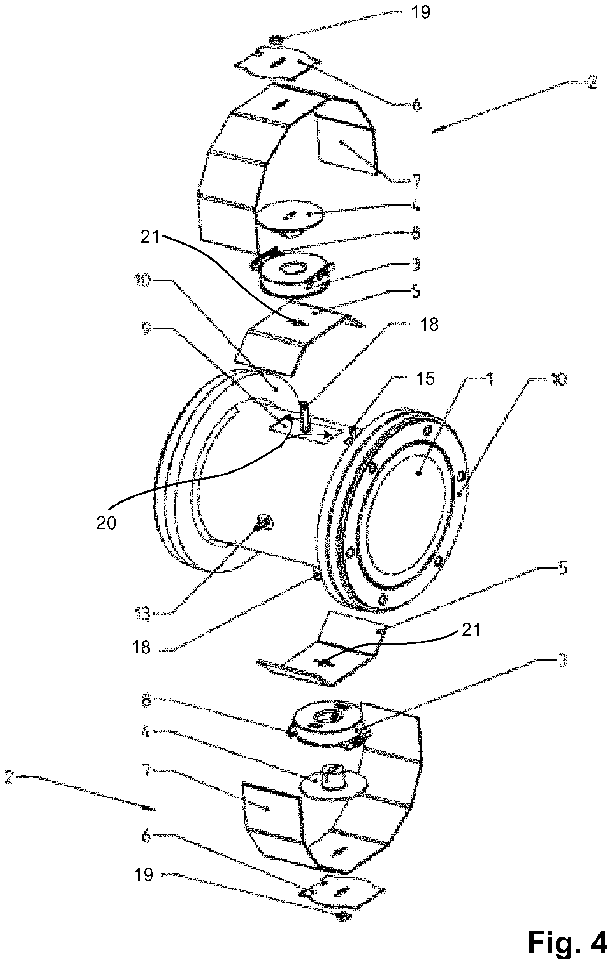

In Fig. 4 ist nun eine weitere Ausgestaltung eines erfindungsgemäßen magnetisch-induktiven Durchflussmessgeräts dargestellt. Die ebene Fläche 9 weist gemäß der dargestellten Ausgestaltung einen axialen Anschlag 20 auf, so dass das komplementär ausgebildete Magnetsystem 2, im montierten Zustand, am axialen Anschlag 20 anliegt. Sie verläuft somit nicht, wie oben auf der gesamten Länge des Messrohrs 1 zwischen beiden Flanschen 10. Hier ist die Ausdehnung der ebenen Fläche in axialer Richtung des Messrohrs 1, also parallel zu einer Längsachse des Messrohrs 1, durch die kreiszylindrische Außenkontur des Messrohrs begrenzt, wodurch zwei axiale Anschläge 20 gebildet werden. Alternativ kann auch zumindest ein axialer Anschlag, beispielsweise in Form eines auf der ebenen Fläche angeordneten Stifts, auf der ebenen Fläche vorgesehen sein.

Der Polschuh 5 weist hier zudem eine Länge auf, welche der Länge der ebenen Fläche 9 in axialer Richtung des Messrohrs 1 entspricht. Der Polschuh 5, als Teil des Magnetsystems 2, ist somit so zur ebenen Fläche 9 geformt, dass er im Bereich der Auflage auf der ebenen Fläche 9 komplementär zu dieser ausgestaltet ist. Im montierten Zustand lässt er sich somit nicht in axialer Richtung des Messrohrs 1 relativ zum Messrohr 1 bewegen. In der dargestellten Ausführungsform fungieren die axialen Anschläge 20 zusätzlich als Verdrehsicherung für das Magnetsystem 2. Dieses lässt sich, an den Anschlägen 20 anliegend, nicht um eine Achse senkrecht auf der ebenen Fläche 9 drehen.

In dieser Achse senkrecht zur ebenen Fläche 9 ragt ein Gewindestift 18 aus der ebenen Fläche 9 heraus, welcher fest mit dem Messrohr 1 verbunden ist. Das Magnetsystem wird auf den Gewindestift 18 gesteckt und anschließend mit einer Mutter 19 unter einem vorgegebenem Drehmoment verschraubt. Auch hier wird somit das Magnetsystem 2 mit einer vorgegebenen Kraft auf das Messrohrs 1 gedrückt.

Hierzu weist der Polschuh 5 eine Bohrung 21 auf, durch welche der Gewindestift 18 geführt wird. Auch die weiteren Bauteile oder Baugruppen des Magnetsystems 2 sind entsprechend ausgeformt. So weist auch der Spulenkern und die Feldrückführung entsprechende Bohrungen auf. Ein wesentlicher Unterschied zum oben beschriebenen Ausgestaltungsbeispiel ist hier, dass das Magnetsystem 2 nicht separat zusammengebaut und als eine Baugruppe auf das Messrohr 1 montiert wird, sondern dass das Magnetsystem 2 auf das Messrohr 1 montiert und somit erst am Messrohr 1 selbst zusammengebaut wird.

Durch die zueinander komplementär ausgestalteten ebene Fläche 9 und Polschuh 5 ist bei der Montage des erfindungsgemäßen Messgeräts die Gefahr, nicht zueinander passende Teile zu verwenden, maßgeblich verringert. Die weiteren Bauteile des Magnetsystems 2 sind entsprechend ebenfalls nach dem Poka-Yoke-Gedanke zueinander aufgebaut.

In einer weiteren bevorzugten Ausgestaltungsvariante der Erfindung ist der Spulenkern 4 und der Polschuh 5 durch Presspassung formschlüssig miteinander verbunden.

Um den Spulenkern herum und über dem Polschuh ist die Spule, vorzugsweise bestehend aus einem Spulenkörper und einem Wickelkörper, angeordnet. Der Spulenkörper kann in einer bevorzugten Ausgestaltung mit größerem Spiel in der Längsachse des Spulenkerns selbstzentriert durch den Spulenkern montiert werden. Dadurch können Fertigungstoleranzen vorteilhaft aufgenommen werden.

Die Spule kann zusätzlich auch Rastmittel aufweisen zur Aufnahme, Positionierung und Orientierung der Feldrückführung 7 an der Anordnung aus Polschuh, Spule und Spulenkern.

Die Anordnung aus Polschuh, Spule, Spulenkern und Feldrückführung kann bevorzugt zu einem magnetfelderzeugenden Modul vormontiert werden, welches durch die Schraubverbindung an dem Messrohr befestigt wird. Die modulare Bauweise dieser Magnetvorrichtung reduziert den Produktionsaufwand, z.B. auch bei der Montage von Kabeln zur Signalübertragung von den Elektroden zum Messumformer durch entsprechend vorgesehene Öffnungen zur Kabelführung im Inneren des felderzeugenden Moduls

Dabei kann die Schraubverbindung bevorzugt über einen einzigen zentral angeordneten Gewindestift ermöglicht werden, welcher direkt am Messrohr befestigt ist, beispielsweise durch eine Schweissverbindung .Dies reduziert die Zahl der Freiheitsgrade im Vergleich zu mehreren Gewindestiften. Weiterhin wird mit weniger Aufwand eine höhere Symmetrie des Aufbaus erreicht, welche sich vorteilhaft auf die Messabweichung auswirkt. Gleichzeitig wird eine erhöhte Verpressung im relevanten Bereich des Übergangs von Rückführung und Spulenkern erreicht, was zu einer Verbesserung der Signalhöhe und Signalstabilität führt.

Für eine möglichst einfache Handhabung, wird die Schraubverbindung jeweils vorzugsweise durch die Mitte der Bauteile des Magnetsystems, insbesondere der Spule, des Spulenkerns, des Polschuhs und/oder der Feldrückführung geführt.

Alternativ oder zusätzlich kann die Fixierung durch den zuvor beschriebenen Montageclip 6 erfolgen.

Wie bereits zuvor beschrieben, ist es insbesondere von Vorteil, wenn der Polschuh des Magnetsystems im Wesentlichen durchbiegefrei, also ohne Verformung, auf dem Messrohr befestigt ist, so dass keine biegungsbedingten Luftspalte zwischen dem Polschuh und dem Spulenkern entstehen. Die Freiräume würden zu einer Reduktion der Empfindlichkeit des Sensors führen und eine Änderung der Grösse der Luftspalte aufgrund von z.B. Temperaturschwankungen oder Vibrationen zu einer Änderung der Messabweichung.

Das Vorspannen erfolgt im Fall der Schraubverbindung durch eine direkte Verbindung zwischen dem Messrohr und dem Magnetsystem. Dabei ist ein Schraubbolzen fest mit dem Messrohr verbunden, beispielsweise durch Verschweißen.

### Bezugszeichenliste

- 1: Messrohr
- 2: Magnetsystem
- 3: Spule
- 4: Spulenkern
- 5: Polschuh
- 6: Montageclip
- 7: Feldrückführung
- 8: Stecker
- 9: Ebene Fläche des Messrohrs
- 10: Flansch
- 11: Ausnehmung
- 12: Gewindebuchse
- 13: Messelektrode
- 14: Schraube
- 15: Messstoffüberwachungselektrode
- 16: Erste ebene Fläche des Polschuhs
- 17: Schenkel des Polschuhs
- 18: Gewindestift
- 19: Mutter
- 20: Axialer Anschlag
- 21: Bohrung im Polschuh zur Durchführung des Gewindestifts oder der Gewindebuchse
- 22: Zweite ebene Fläche des Polschuhs
- 23: Spulenkörper

## Patentansprüche

1. Magnetisch-induktives Durchflussmessgerät mit einem Messrohr (1) und zumindest einem am Messrohr angeordnetem Magnetsystem (2),
**dadurch gekennzeichnet,**
**dass** das Messrohr (1) zumindest eine ebene Fläche (9) und eine ansonsten zylindrische Mantelfläche aufweist, welche das Messrohr zur Umwelt hin begrenzen, gegen welche ebene Fläche (9) das Magnetsystem (2) vorgespannt ist,
wobei das Magnetsystem (2) mittels einer Schraubverbindung (18, 19) zwischen Messrohr (1) und Magnetsystem (2) gegen die ebene Fläche (9) des Messrohrs (1) vorgespannt ist, und dass das Magnetsystem (2) eine Spule (3) und einen Polschuh (5) umfasst, wobei die Spule (3) einen Spulenkern (4) umfasst, wobei der Polschuh (5) mit der vorgegebenen Kraft gegen die ebene Fläche (9) des Messrohrs (1) vorgespannt ist und wobei der Spulenkern (4) mit derselben vorgegebenen Kraft gegen den Polschuh (5) vorgespannt ist.

2. Magnetisch-induktives Durchflussmessgerät mit einem Messrohr (1) und zumindest einem am Messrohr angeordnetem Magnetsystem (2),
**dadurch gekennzeichnet,**
**dass** das Messrohr (1) zumindest eine ebene Fläche (9) und eine ansonsten zylindrische Mantelfläche aufweist, welche das Messrohr zur Umwelt hin begrenzen, gegen welche ebene Fläche (9) das Magnetsystem (2) vorgespannt ist, und
wobei das Magnetsystem (2) mittels eines Montageclips (6) gegen die ebene Fläche (9) des Messrohrs (1) vorgespannt ist, welcher am Messrohr (1) formschlüssig befestigt ist, und
**dass** das Magnetsystem (2) eine Spule (3) und einen Polschuh (5) umfasst, wobei die Spule (3) einen Spulenkern (4) umfasst, wobei der Polschuh (5) mit der vorgegebenen Kraft gegen die ebene Fläche (9) des Messrohrs (1) vorgespannt ist und wobei der Spulenkern (4) mit derselben vorgegebenen Kraft gegen den Polschuh (5) vorgespannt ist.

3. Magnetisch-induktives Durchflussmessgerät nach Anspruch 2,
**dadurch gekennzeichnet,**
**dass** der Montageclip (6) in zumindest eine Ausnehmung (11) in einem Flansch (10) des Messrohrs (1) eingreift.

4. Magnetisch-induktives Durchflussmessgerät nach einem der Anspruch 2 oder 3,
**dadurch gekennzeichnet,**
**dass** ein Steckverbindungselement (8) zum elektrischen Anschluss des Magnetsystems (2) am Magnetsystem (2) angeordnet ist, wobei das Steckverbindungselement (8) zwischen dem Montageclip (6) und dem Messrohr (1) angeordnet ist.

5. Magnetisch-induktives Durchflussmessgerät nach einem der Ansprüche 2 bis 4,
**dadurch gekennzeichnet,**
**dass** das Magnetsystem (2) einen Polschuh (5), eine Spule (3) und ein Feldrückführblech (7) umfasst, wobei das Feldrückführblech (7) zwischen Spule (3) und Montageclip (2) angeordnet ist und wobei die Spule (3) zwischen Polschuh (5) und Feldrückführblech (7) angeordnet ist.

6. Magnetisch-induktives Durchflussmessgerät nach einem der Ansprüche 1 bis 5,
**dadurch gekennzeichnet,**
**dass** das Magnetsystem (2) einen Polschuh (5) umfasst, welcher eine ebene Fläche (16) aufweist, welche quer zu einer Längsachse des Messrohrs (1) breiter ist, als die ebene Fläche (9) des Messrohrs (1).

7. Magnetisch-induktives Durchflussmessgerät nach einem der Ansprüche 1 bis 6,
**dadurch gekennzeichnet,**
**dass** das Magnetsystem (2) eine Spule (3) und einen Polschuh (5) umfasst, wobei der Polschuh (5) einen Stift oder eine Buchse (12) aufweist, auf weichen die Spule (3) aufgesteckt ist, wobei der Polschuh (5) so zum Messrohr (1) ausgerichtet ist, dass der Stift oder die Buchse (12) eine Längsachse aufweist, welche mit einem Durchmesser des Messrohrs (1) zusammenfällt.

8. Magnetisch-induktives Durchflussmessgerät nach einem der Ansprüche 1 bis 7,
**dadurch gekennzeichnet,**
**dass** das Magnetsystem einen Polschuh (5) und einen Spulenkern (4) umfasst, welcher Spulenkern (4) eine zum Polschuh (5) komplementäre Kontur aufweist.

9. Magnetisch-induktives Durchflussmessgerät nach einem der Ansprüche 4 bis 8,
**dadurch gekennzeichnet,**
**dass** eine gedachte Ebene, in welcher die Messrohrachse liegt und welche die ebene Fläche (9) des Messrohrs senkrecht schneidet, die ebene Fläche (9) des Messrohrs (1) in zwei gleich große Teile teilt, wobei der Polschuh (5) spiegelsymmetrisch um die gedachten Ebene als Spiegelebene aufgebaut ist.

10. Magnetisch-induktives Durchflussmessgerät nach einem der Ansprüche 5 bis 9,
**dadurch gekennzeichnet,**
**dass** der Polschuh (5) so zum Messrohr (1) geformt ist, dass er die ebene Fläche (9) des Messrohrs (1) berührt und einen vorgegebenen Mindestabstand zur ansonsten zylindrischen Mantelfläche des Messrohrs (1) aufweist, wobei er das Messrohr (1) in einem Kreisbogenwinkel von zumindest 10° umschließt.

11. Magnetisch-induktives Durchflussmessgerät nach einem der Ansprüche 1 bis 10,
**dadurch gekennzeichnet,**
**dass** die ebene Fläche (9) in axialer Richtung des Messrohrs (1) einen axialen Anschlag (20) für das Magnetsystem (2) aufweist.

12. Magnetisch-induktives Durchflussmessgerät nach einem der Ansprüche 1 bis 11,
**dadurch gekennzeichnet,**
**dass** das Messrohr (1) eine zur Messrohrachse parallele und zur ebenen Fläche (9) planparallele, weitere ebene Fläche (9) aufweist, gegen welche ein weiteres, insbesondere baugleiches, Magnetsystem (2) vorgespannt ist.

13. Verfahren zum Herstellen eines magnetisch-induktiven Durchflussmessgeräts nach einem der Ansprüche 1 oder 5-12,
**dadurch gekennzeichnet,**
**dass** ein eine kreiszylinderförmige Mantelfläche aufweisendes Messrohr (1) mit einer ebenen Fläche (9) versehen wird, wogegen das Magnetsystem (2) vorgespannt wird, wobei das Magnetsystem (2) mittels einer Schraubverbindung (18, 19) zwischen Messrohr (1) und Magnetsystem (2) gegen die ebene Fläche (9) des Messrohrs (1) vorgespannt wird und dass das Magnetsystem (2) eine Spule (3) und einen Polschuh (5) umfasst, wobei die Spule (3) einen Spulenkern (4) umfasst, wobei der Polschuh (5) mit der vorgegebenen Kraft gegen die ebene Fläche (9) des Messrohrs (1) vorgespannt ist und wobei der Spulenkern (4) mit derselben vorgegebenen Kraft gegen den Polschuh (5) vorgespannt wird.

14. Verfahren zum Herstellen eines magnetisch-induktiven Durchflussmessgeräts nach einem der Ansprüche 2 bis 12,
**dadurch gekennzeichnet,**
**dass** ein eine kreiszylinderförmige Mantelfläche aufweisendes Messrohr (1) mit einer ebenen Fläche (9) versehen wird, wogegen das Magnetsystem (2) vorgespannt wird, wobei das Magnetsystem (2) mittels eines Montageclips (6) gegen die ebene Fläche (9) des Messrohrs (1) vorgespannt ist, welcher am Messrohr (1) formschlüssig befestigt wird und
**dass** das Magnetsystem (2) eine Spule (3) und einen Polschuh (5) umfasst, wobei die Spule (3) einen Spulenkern (4) umfasst, wobei der Polschuh (5) mit der vorgegebenen Kraft gegen die ebene Fläche (9) des Messrohrs (1) vorgespannt ist und wobei der Spulenkern (4) mit derselben vorgegebenen Kraft gegen den Polschuh (5) vorgespannt wird.

15. Verfahren nach Anspruch 13 oder 14, **dadurch gekennzeichnet, dass** zunächst eine Vormontage des Magnetsystems erfolgt und anschließend dieses durch den Montageclip (6) und/oder eine Schraubverbindung auf dem Messrohr befestigt wird.

## Claims

1. Electromagnetic flowmeter with a measuring tube (1) and at least a magnet system (2) arranged on the measuring tube (2),
**characterized in that**
the measuring tube (1) has at least a planar surface (9) and an otherwise cylindrical lateral surface which delimit the measuring tube in relation to the environment, wherein the magnet system (2) is pretensioned against said planar surface (9),
wherein the magnet system (2) is pretensioned against the planar surface (9) of the measuring tube (1) by means of a screw connection (18, 19) between the measuring tube (1) and the magnet system (2), and **in that** the magnet system (2) comprises a coil (3) and a pole piece (5), wherein the coil (3) has a coil core (4), wherein the pole piece (5) is pretensioned against the planar surface (9) of the measuring tube (1) with the predefined force, and wherein the coil core (4) is pretensioned against the pole piece (5) with the same predefined force.

2. Electromagnetic flowmeter with a measuring tube (1) and at least a magnet system (2) arranged on the measuring tube (2),
**characterized in that**
the measuring tube (1) has at least a planar surface (9) and an otherwise cylindrical lateral surface which delimit the measuring tube in relation to the environment, wherein the magnet system (2) is pretensioned against said planar surface (9), and
wherein the magnet system (2) is pretensioned against the planar surface (9) of the measuring tube (1) by means of a mounting clip (6), which is secured to the measuring tube (1) via a positive locking connection, and
**in that** the magnet system (2) comprises a coil (3) and a pole piece (5), wherein the coil (3) has a coil core (4), wherein the pole piece (5) is pretensioned against the planar surface (9) of the measuring tube (1) with the predefined force, and wherein the coil core (4) is pretensioned against the pole piece (5) with the same predefined force.

3. Electromagnetic flowmeter as claimed in Claim 2,
**characterized in that**
the mounting clip (6) engages in at least a cavity (11) in a flange (10) of the measuring tube (1).

4. Electromagnetic flowmeter as claimed in Claim 2 or 3,
**characterized in that**
a plug-in connection element (8) designed to electrically connect the magnet system (2) is arranged on the magnet system (2), wherein the plug-in connection element (8) is arranged between the mounting clip (6) and the measuring tube (1).

5. Electromagnetic flowmeter as claimed in one of the Claims 2 to 4,
**characterized in that**
the magnet system (2) comprises a pole piece (5), a coil (3) and a field return plate (7), wherein the field return plate (7) is arranged between the coil (3) and the mounting clip (2), and wherein the coil (3) is arranged between the pole piece (5) and the field return plate (7).

6. Electromagnetic flowmeter as claimed in one of the Claims 1 to 5,
**characterized in that**
the magnet system (2) comprises a pole piece (5), which has a planar surface (16), which is broader perpendicular to a longitudinal axis of the measuring tube (1) than the planar surface (9) of the measuring tube (1).

7. Electromagnetic flowmeter as claimed in one of the Claims 1 to 6,
**characterized in that**
the magnet system (2) comprises a coil (3) and a pole piece (5), wherein the pole piece (5) comprises a male or female connector (12) to which the coil (3) is attached, wherein the pole piece (5) is aligned in relation to the measuring tube (1) in such a way that the male or female connector (12) has a longitudinal axis which coincides with a diameter of the measuring tube (1).

8. Electromagnetic flowmeter as claimed in one of the Claims 1 to 7,
**characterized in that**
the magnet system comprises a pole piece (5) and a coil core (4), wherein said coil core (4) has a contour that is complementary to the pole piece (5).

9. Electromagnetic flowmeter as claimed in one of the Claims 4 to 8,
**characterized in that**
an imaginary plane in which the measuring tube axis is located and which perpendicularly cuts the planar surface (9) of the measuring tube, divides the planar surface (9) of the measuring tube (1) into two equal parts, wherein the pole piece (5) is designed as a plane of symmetry in mirror symmetry around the imaginary plane.

10. Electromagnetic flowmeter as claimed in one of the Claims 5 to 9,
**characterized in that**
the pole piece (5) is formed in relation to the measuring tube (1) in such a way that it touches the planar surface (9) of the measuring tube (1) and has a predefined minimum distance to the otherwise cylindrical lateral surface of the measuring tube (1), wherein the pole piece surrounds the measuring tube (1) in a arc angle of at least 10°.

11. Electromagnetic flowmeter as claimed in one of the Claims 1 to 10,
**characterized in that**
the planar surface (9) has an axial stop (20) for the magnet system (2) in the axial direction of the measuring tube (1).

12. Electromagnetic flowmeter as claimed in one of the Claims 1 to 11,
**characterized in that**
the measuring tube (1) has an additional planar surface (9) that is parallel to the measuring tube axis and plane-parallel to the planar surface (9), against which an additional magnet system (2) is pretensioned, particularly a magnet system that is identical in design.

13. Method for the fabrication of an electromagnetic flowmeter as claimed in one of the Claims 1 or 5 to 12,
**characterized in that**
a measuring tube (1) having a cylindrical lateral surface is provided with a planar surface (9) against which the magnet system (2) is pretensioned, wherein the magnet system (2) is pretensioned against the planar surface (9) of the measuring tube (1) by means of a screw connection (18, 19) between the measuring tube (1) and the magnet system (2), and **in that** the magnet system (2) comprises a coil (3) and a pole piece (5), wherein the coil (3) has a coil core (4), wherein the pole piece (5) is pretensioned with the predefined force against the planar surface (9) of the measuring tube (1), and wherein the coil core (4) is pretensioned with the same predefined force against the pole piece (5).

14. Method for the fabrication of an electromagnetic flowmeter as claimed in one of the Claims 2 to 12,
**characterized in that**
a measuring tube (1) having a cylindrical lateral surface is provided with a planar surface (9) against which the magnet system (2) is pretensioned, wherein the magnet system (2) is pretensioned against the planar surface (9) of the measuring tube (1) by means of a mounting clip (6) which is secured to the measuring tube (1) via a positive locking connection
and
**in that** the magnet system (2) comprises a coil (3) and a pole piece (5), wherein the coil (3) has a coil core (4), wherein the pole piece (5) is pretensioned with the predefined force against the planar surface (9) of the measuring tube (1), and wherein the coil core (4) is pretensioned with the same force against the pole piece (5).

15. Procedure as claimed in Claim 13 or 14,
**characterized in that**
the magnet system is first premounted and is the secured to the measuring tube by means of the mounting clip (6) and/or a screw connection.

## Revendications

1. Débitmètre magnéto-inductif avec un tube de mesure (1) et au moins un système magnétique (2) disposé sur le tube de mesure (2),
**caractérisé**
**en ce que** le tube de mesure (1) présente au moins une surface plane (9) et par ailleurs une surface d'enveloppe cylindrique, lesquelles délimitent le tube de mesure par rapport à l'environnement, surface plane (9) contre laquelle le système magnétique (2) est précontraint,
pour lequel le système magnétique (2) est précontraint au moyen d'un assemblage vissé (18, 19) entre le tube de mesure (1) et le système magnétique (2) contre la surface plane (9) du tube de mesure (1), et en ce que le système magnétique (2) comprend une bobine (3) et une pièce polaire (5), la bobine (3) comprenant un noyau de bobine (4), la pièce polaire (5) étant précontrainte avec la force prédéfinie contre la surface plane (9) du tube de mesure (1), et le noyau de bobine (4) étant précontraint avec la même force prédéfinie contre la pièce polaire (5).

2. Débitmètre magnéto-inductif avec un tube de mesure (1) et au moins un système magnétique (2) disposé sur le tube de mesure (2),
**caractérisé**
**en ce que** le tube de mesure (1) présente au moins une surface plane (9) et par ailleurs une surface d'enveloppe cylindrique, lesquelles délimitent le tube de mesure par rapport à l'environnement, surface plane (9) contre laquelle le système magnétique (2) est précontraint,
pour lequel le système magnétique (2) est précontraint au moyen d'un clip de montage (6) contre la surface plane (9) du tube de mesure (1), lequel clip est fixé de façon rigide sur le tube de mesure (1), et en ce que le système magnétique (2) comprend une bobine (3) et une pièce polaire (5), la bobine (3) comprenant un noyau de bobine (4), la pièce polaire (5) étant précontrainte avec la force prédéfinie contre la surface plane (9) du tube de mesure (1), et le noyau de bobine (4) étant précontraint avec la même force prédéfinie contre la pièce polaire (5).

3. Débitmètre magnéto-inductif selon la revendication 2,
**caractérisé**
**en ce que** le clip de montage (6) s'engage dans au moins une cavité (11) d'une bride (10) du tube de mesure (1).

4. Débitmètre magnéto-inductif selon la revendication 2 ou 3,
**caractérisé**
**en ce qu'**un élément de connexion (8) destiné au raccordement électrique du système magnétique (2) est disposé sur le système magnétique (2), l'élément de connexion (8) étant disposé entre le clip de montage (6) et le tube de mesure (1).

5. Débitmètre magnéto-inductif selon l'une des revendications 2 à 4,
**caractérisé**
**en ce que** le système magnétique (2) comprend une pièce polaire (5), une bobine (3) et une tôle de retour de champ (7), la tôle de retour de champ (7) étant disposée entre la bobine (3) et le clip de montage (2), et la bobine (3) étant disposée entre la pièce polaire (5) et la tôle de retour de champ (7).

6. Débitmètre magnéto-inductif selon l'une des revendications 1 à 5,
**caractérisé**
**en ce que** le système magnétique (2) comprend une pièce polaire (5), qui présente une surface plane (16), laquelle est, à la perpendiculaire d'un axe longitudinal du tube de mesure (1), plus large que la surface plane (9) du tube de mesure (1).

7. Débitmètre magnéto-inductif selon l'une des revendications 1 à 6,
**caractérisé**
**en ce que** le système magnétique (2) comprend une bobine (3) et une pièce polaire (5), la pièce polaire (5) comportant un connecteur mâle ou femelle (12), auquel la bobine (3) est branchée, la pièce polaire (5) étant alignée par rapport au tube de mesure (1) de telle sorte que le connecteur mâle ou femelle (12) présente un axe longitudinal qui coïncide avec un diamètre du tube de mesure (1).

8. Débitmètre magnéto-inductif selon l'une des revendications 1 à 7,
**caractérisé**
**en ce que** le système magnétique comprend une pièce polaire (5) et un noyau de bobine (4), lequel noyau de bobine (4) présente un contour complémentaire à la pièce polaire (5).

9. Débitmètre magnéto-inductif selon l'une des revendications 4 à 8,
**caractérisé**
**en ce qu'**un plan imaginaire, dans lequel se trouve l'axe de tube de mesure et qui coupe perpendiculairement la surface plane (9) du tube de mesure, partage la surface plane (9) du tube de mesure (1) en deux partie de grandeur égale, la pièce polaire (5) étant conçue en tant que plan de symétrie selon une symétrie spéculaire autour du plan imaginaire.

10. Débitmètre magnéto-inductif selon l'une des revendications 5 à 9,
**caractérisé**
**en ce que** la pièce polaire (5) est formée par rapport au tube de mesure (1) de telle sorte à ce qu'elle touche la surface plane (9) du tube de mesure (1) et présente une distance minimale prédéfinie par rapport à la surface d'enveloppe par ailleurs cylindrique, la pièce polaire entourant le tube de mesure (1) selon un angle d'arc d'au moins 10°.

11. Débitmètre magnéto-inductif selon l'une des revendications 1 à 10,
**caractérisé**
**en ce que** la surface plane (9) présente en direction axiale du tube de mesure (1) une butée axiale (20) pour le système magnétique (2).

12. Débitmètre magnéto-inductif selon l'une des revendications 1 à 11,
**caractérisé**
**en ce que** le tube de mesure (1) présente une surface plane supplémentaire (9) parallèle à l'axe de tube de mesure et plane et parallèle à la surface plane (9), contre laquelle un système magnétique (2) supplémentaire, notamment de conception identique, est précontraint.

13. Procédé destiné à la fabrication d'un débitmètre magnéto-inductif (1) selon l'une des revendications 1 ou 5 à 12,
**caractérisé**
**en ce qu'**un tube de mesure (1) présentant une surface d'enveloppe circulaire cylindrique est pourvu d'une surface plane (9), contre laquelle le système magnétique (2) est précontraint, le système magnétique (2) étant précontraint au moyen d'un assemblage vissé (18, 19) entre le tube de mesure (1) et le système magnétique (2) contre la surface plane (9) du tube de mesure (1), et en ce que le système magnétique (2) comprend une bobine (3) et une pièce polaire (5), la bobine (3) comprenant un noyau de bobine (4), la pièce polaire (5) étant précontrainte avec la force prédéfinie contre la surface plane (9) du tube de mesure (1), et le noyau de bobine (4) étant précontraint avec la même force prédéfinie contre la pièce polaire (5).

14. Procédé destiné à la fabrication d'un débitmètre magnéto-inductif (1) selon l'une des revendications 2 à 12,
**caractérisé**
**en ce qu'**un tube de mesure (1) présentant une surface d'enveloppe circulaire cylindrique est pourvu d'une surface plane (9), contre laquelle le système magnétique (2) est précontraint, le système magnétique (2) étant précontraint au moyen d'un clip de montage (6) contre la surface plane (9) du tube de mesure (1), lequel clip est fixé de façon rigide sur le tube de mesure (1)
et
et **en ce que** le système magnétique (2) comprend une bobine (3) et une pièce polaire (5), la bobine (3) comprenant un noyau de bobine (4), la pièce polaire (5) étant précontrainte avec la force prédéfinie contre la surface plane (9) du tube de mesure (1), et le noyau de bobine (4) étant précontraint avec la même force prédéfinie contre la pièce polaire (5).

15. Procédé selon la revendication 13 ou 14,
**caractérisé**
**en ce qu'**est d'abord effectué un prémontage du système magnétique, puis celui-ci est fixé par un clip de montage (6) et/ou un assemblage vissé sur le tube de mesure.
